# EUROPEAN PATENT SPECIFICATION

(11) **EP 1 664 928 B1**
(45) Date of publication and mention of the grant of the patent: **29.02.2012**
(21) Application number: 04772191.5
(22) Date of filing: 19.08.2004
(51) Int. Cl.: G03F 7/023

(54) **POSITIVE PHOTORESIST COMPOSITION AND RESIST PATTERN FORMATION**
POSITIV-PHOTORESISTZUSAMMENSETZUNG UND BILDUNG EINER RESISTSTRUKTUR
COMPOSITION DE PHOTORESINE POSITIVE ET FORMATION DE MOTIF DE RESINE

(30) Priority: 18.09.2003 JP 2003325953
(43) Date of publication of application: 07.06.2006
(73) Proprietor: TOKYO OHKA KOGYO CO., LTD., Kawasaki-shi, Kanagawa 211-0012 (JP)
(72) Inventor: MASUDA, Yasuo, Kawasaki-shi, Kanagawa 211-0012 (JP); OKUI, Toshiki, Kawasaki-shi, Kanagawa 211-0012 (JP)
(74) Representative: Hart-Davis, Jason
(86) International application number: PCT/JP2004/012235
(87) International publication number: WO 2005/029184

(56) References cited:
- EP-A1- 1 055 969
- EP-A1- 1 085 378
- GB-A- 2 240 549
- US-A- 5 314 782
- US-A- 5 422 221
- US-B1- 6 210 855

## Description

### TECHNICAL FIELD

The present invention relates to a positive photoresist composition and to a resist pattern formation method.

Priority is claimed on Japanese Patent Application No. 2003-325953, filed September 18, 2003, the content of which is incorporated herein by reference.

### BACKGROUND ART

In photolithography technology, the positive photoresist composition which mainly contains an alkali soluble resin and a quinonediazide group containing compound as a photosensitizer is conventionally used for manufacture of a semiconductor device or a liquid crystal element. This positive photoresist composition has the characteristics of being able to be equal to practical use, in the manufacture of a semiconductor device or a liquid crystal element. However, in the steps in a manufacture field which requires thick film process, such as, for example, the bump formation process of an LCD driver etc., the maximum wiring process of CSP (Chip Size/Scale Package), the process which forms the magnetic coil of a magnetic head, it is required to form a resist pattern with sufficient perpendicularity, at a high sensitivity and with a high development velocity under, for example, thick film conditions of 3 µm or more. However, it is difficult to satisfy the requirement under such thick film conditions using the conventional positive photoresist composition.

On the other hand, positive photoresist compositions which comprise photosensitive novolak resin formed from an alkali soluble novolak resin wherein some hydrogen atoms within those of all phenolic hydroxyl groups of the resin are substituted by 1,2-naphthoquinone diazide sulfonyl groups are described as a material suitable for the exposure process under thick film conditions in patent documents 1-4.
[Patent document 1] Japanese Unexamined Patent Application, First Publication No. 2001-312052
[Patent document 2] Japanese Unexamined Patent Application, First Publication No. 2001-312059
[Patent document 3] japanese Unexamined Patent Application, First Publication No. 2001-312060
[Patent document 4] Japanese Unexamined Patent Application, First Publication No. 2001-312066

However, according to research of the present inventors, although the positive photoresist composition comprising a photosensitive novolak resin formed from an alkali soluble novolak resin wherein some hydrogen atoms within those of all phenolic hydroxy) groups of the alkali soluble novolak resin is substituted by 1,2-naphthoquinone diazide sulfonyl group is suitable for realising the perpendicularity and high sensitivity of a resist pattern in a thick film, the composition has a problem that development velocity thereof is slow.

### DISCLOSURE OF THE INVENTION

Therefore, an object of the present invention is to increase the development velocity of the positive photoresist composition comprising a photosensitive novolak resin formed from an alkali soluble novolak resin wherein some hydrogen atoms within those of all phenolic hydroxyl groups of the alkali soluble novolak resin are substituted by 1,2-naphthoquinone diazide sulfonyl group.

In order to attain the above-mentioned purpose, the present invention adopts the following features.

The first aspect of the present invention is a positive photoresist composition according to appended claim 1.

The second aspect of the present invention is a resist pattern formation method comprising the steps of coating a positive photoresist composition of the present invention on a substrate, prebaking the coated film, selectively exposing the film, and subsequently alkali developing the film.

### Effects of the Invention

According to the present invention, the development velocity of the positive photoresist composition comprising a photosensitive novolak resin formed from an alkali soluble novolak resin wherein some hydrogen atoms within those of all phenolic hydroxyl groups of the alkali soluble novolak resin are substituted by 1.2-naphthoquinone diazide sulfonyl group can be increased.

### BRIEF DESCRIPTION OF THE DRAWINGS

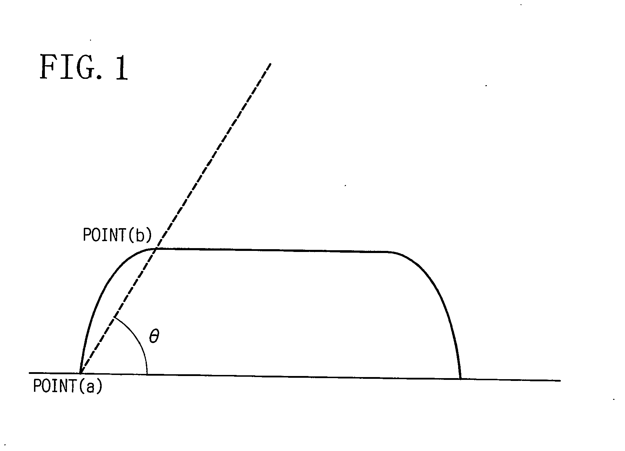

Fig. 1 is a diagram showing the measuring method of an Example.

### BEST MODE FOR CARRYING OUT THE INVENTION

### [positive photoresist composition]

### (A) component (photosensitive novolak resin)

The component (A) is a photosensitive novolak resin formed from an alkali soluble novolak resin wherein some hydrogen atoms within those of all phenolic hydroxyl groups of the alkali soluble novolak resin are substituted by 1,2-naphthoquinonediazide sulfonyl group.

By using the component (A) the perpendicularity of the form of a resist pattern and a good sensitivity are obtained.

The component (A) can be synthesized through an esterification reaction of an alkali soluble novolak resin and a 1,2-naphthoquinone diazide sulfonic acid compound. The alkali soluble novolak resin can be synthesized as a polycondensation material through the dehydration condensation reaction of a phenolic compound and a condensing agent according to a usual method, such as is disclosed in Japanese Unexamined Patent Application, First Publication No. 10-97066, for example. - 1, 2-naphthoquinone diazide sulfonic acid compound

Examples of the above 1,2-naphthoquinone diazide sulfonic acid compound includes, e.g., halide of quinone diazide compounds, such as 1,2-naphthoquinone diazide-4-sulfonic acid chloride, 1,2-naphthoquinone diazide-5-sulfonic acid chloride.

### - Alkali soluble novolak resin

As examples of the above phenolic compound which may be used for synthesis of an alkali soluble novolak resin, the phenolic compound corresponding to the constitutional unit represented by the following formulas (a-1) to (a-5) can be mentioned.

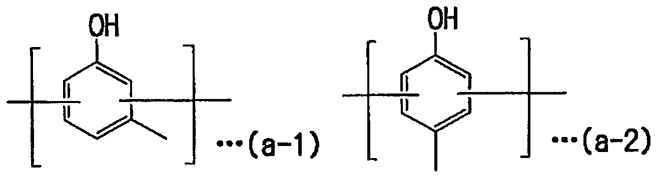

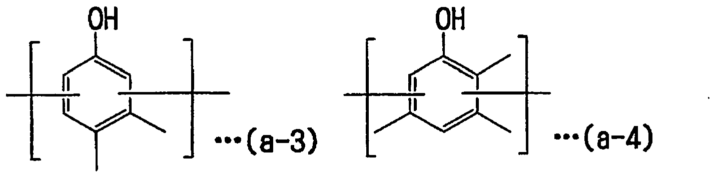

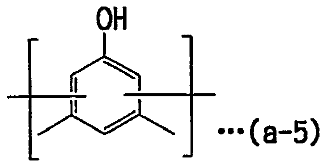

For example, as a phenolic compound corresponding to the constitutional unit represented by the above formula (a-1), m-cresol can be mentioned;
as a phenolic compound corresponding to the constitutional unit represented by the above formula (a-2), p-cresol can be mentioned;
as a phenolic compound corresponding to the constitutional unit represented by the above formula (a-3), 3,4-xylenol can be mentioned;
as a phenolic compound corresponding to the constitutional unit represented by the above formula (a-4), 2,3,5-trimethylphenol can be mentioned; and
as a phenolic compound corresponding to the above formula (a-5), 3,5-xylenol can be mentioned.

Moreover, although phenolic compounds other than the above can also be used, as for these, it is desirable to use such phenolic compounds in an amount not more than 10 mol % based on all phenolic compounds from the viewpoint of not spoiling various characteristics of the positive photoresist composition of the present invention.

As the above condensing agent, aldehydes and ketones conventionally used for synthesis of phenol novolak resin can be mentioned, and aldehydes, especially formaldehyde is particularly preferable.

Alkali soluble novolak resins satisfy the following characteristics shown bellow at items (1) to (3).
(1) the polystyrene equivalent weight average molecular weight of 1000-30000, preferably 2000-10000, (2) degree of dispersion of 25 or less, preferably ten or less, and (3) the dissolution rate to a 2.38 % by weight TMAH (tetramethyl ammonium hydroxide) aqueous solution (23°C) of 10 to 1000Å/s, preferably 50 to 500Å/s.

When the weight average molecular weight is 1000 or more, as shown in the above (1), thickness loss of the non-exposed part at the time of development can be controlled, and when the weight average molecular weight is 30000 or less, the fall of development velocity and resolvability can be controlled.

When the degree of dispersion is 25 or less as shown in above (2), it is advantageous in acquiring resolvability and good form.

When the dissolution rate is 10Å/s or more, thickness loss of the non-exposed part at the time of development can be controlled, and the fall of development velocity can be controlled by being 1000Å/s or less.

Here, the value of the dissolution rate of alkali soluble novolak resin in this specification is a value specifically calculated as follows. First, on a silicone wafer, a solution (concentration: 22 % by weight) formed by dissolving an alkali soluble novolak resin in propylene glycol methyl ether acetate is applied, the resulting coating is prebaked for 90 seconds at 110° C, and the resin film of 10000 Å thickness is formed. Next, this wafer is dipped in a 2.38 % by weight TMAH developer at 23°C. The time for the resin film to dissolve completely is measured and the amount of thickness loss of the resin film per unit time (Å/s) is calculated therefrom.

The thus obtained amount of thickness losses of the resin film per unit time is the dissolution rate of alkali soluble novolak resin in this specification.

### - (A) component (Photosensitive novolak resin)

The polystyrene equivalent weight average molecular weight (Mw) obtained by a Gel Permeation Chromatography (GPC) of an alkali soluble novolak resin of the (A) component before substitution by 1,2-naphthoquinone diazide sulfonyl group, is preferably 1000-30000, and more preferably 2000-10000. By making the Mw 1000 or more, a tendency can be controlled of a remarkable thickness loss of a non-exposed part and a difficulty in formation of a resist pattern at the time when the development take place. Moreover, by making the Mw 30000 or less, a tendency for development velocity and resolvability to decrease remarkably can be controlled.

Moreover, the alkali soluble novolak resin of (A) component before substitution by 1,2-naphthoquinone diazide sulfonyl group can, if necessary, be decreased in low molecular weight components content, by fractionation processing not more than in 80 % by weight, more preferably not more than 50 % by weight before this fractionation processing.

Here, the low molecular weight component means the above phenolic compound, i.e., phenolic monomer, the dimer obtained from the phenolic compound, the dimer obtained from the phenolic monomer of the phenolic compound, and the trimmer obtained from phenolic monomer and the like.

By using such fractionated resin, the perpendicularity of the resist pattern sectional form becomes still better, the generation of a residual substance (scums) on the substrate after development decreases, and resolvability improves. Moreover, the resist becomes excelled in heat resistance.

The fractionation processing can be performed by a well-known fractionation processing method, for example, by the following fractional precipitation processings. First, as mentioned above, after performing the dehydration condensation reaction of a phenolic compound and a condensing agent, the obtained polycondensation product (novolak resin) is dissolved in a polar solvent, and poor solvents, such as water, heptane, hexane, pentane, and cyclohexane, or the like is added to the resulting solution. Since low molecular weight components have comparatively high solubility and they are dissolved in the poor solvent at this time, the fractionated resin with which the content of low molecular weight components are reduced can be obtained by filtrating deposited materials.

Examples of the above polar solvent are alcohols, such as methanol and ethanol; ketones, such as acetone, and methyl ethyl ketone; glycol ether esters, such as ethylene glycol monoethyl ether acetate; and cyclic ethers, such as tetrahydrofuran, etc.

The content of low molecular weight components in alkali soluble novolak resin of the (A) component before substitution by 1,2-naphthoquinone diazide sulfonyl group can be checked from the result of GPC measurement. That is, from a GPC chart, the molecular weight distribution of the synthesized phenol novolak resin can be checked, and the content can be calculated by measuring the intensity ratio of the peak corresponding to the elution time of low molecular weight components.

In addition, since the elution time of the low molecular weight component changes with measurement means, specification of a column, an eluate, a flow rate, temperature, a detecting element, sample concentration, an injection rate, a measuring instrument, etc., is important for it. In the present invention, by using the following measurement means, the elution time of a phenolic monomer can be assigned to around 23 to 25 minutes, the elution time of a dimer can be assigned to around 22 minutes, and a trimer's elution time can be assigned to around 21 minutes, respectively.

### (Measurement means of GPC in the present invention)

(1) 20mg of a sample is dissolved in 10ml of tetrahydrofuran (THF), and a sample solution is prepared.
(2) 10 microliters of sample solutions of (1) is poured into following GPC measurement equipment and is flowed for 28 minutes, and the elution time of the sample detected near UV wavelength λ= 280nm is measured.

### (Measurement equipment)

GPC measurement equippment (trade name: "GPC SYSTEM 11"; manufactured by Shodex) provided with a guard column (trade name: "KF-G"; manufactured by Shodex), and three separation columns (trade name: "KF-801"; manufactured by Shodex; column size 8 µm (diameter) ×300mm (length); packed with styrene-divinylbenzene copolymer of 6 µm grain size; ), the separation column temperature being set at 40°C.

Elution liquid passing velocity of the eluate tetrahydrofuran (THF) is performed on condition of 1.0 ml/min.

The degree of dispersion [Mw/number average molecular weight (Mn)] of fractionation resin is preferably 3.0 or less, and more preferably 2.2 to 2.8. By making Mw/Mn 3.0 or less, the resolvability, the perpendicularity of a resist pattern, and the heat resistance of the positive photoresist composition of the present invention improve.

The alkali soluble novolak resin component of the (A) component before substitution by 1,2-naphthoquinone diazide sulfonyl group comprises, within all phenolic constitutional units, a combination of the constitutional unit of the above formula (a-1), and at least one constitutional unit selected from the above formula (a-2), (a-3), (a-4) and (a-5) in respect of developability, resolvability, and form.

The rate of the hydrogen atoms which is substituted by 1,2-naphthoquinonediazide sulfonyl group within the hydrogen atoms of all phenolic hydroxyl groups of alkali soluble novolak resin in the (A) component, i.e., the reaction rate of an esterification reaction, is preferably 2 to 20 mol %, more preferably 2 to 10 mol %, further more preferably 3 to 7 mol %, and most preferably 3 to 5 mol %.

By making the reaction rate 2 mol % or more, the tendency of the thickness loss of a non-exposed portion can be controlled. On the other hand, by making the reaction rate 20 mol % or less, the tendency of the permeability decrease for i-line radiation can be controlled and decrease of sensitivity can be controlled, without impairing various characteristics. Also, the fall of the perpendicularity of form can be controlled. As the (A) component, one kind or a mixture of two or more kinds thereof can be used.

### (B) organic solvent

### - Propylene glycol alkyl ether acetate

By using propylene glycol, alkyl ether acetate as part of the (B) component. development velocity can be increased. If the (B) component is used, the dissolution rate can be increased, without causing thickness loss of the non-exposed part by development. Furthermore, development velocity can be increased, maintaining the effect by the (A) component, i.e., the good sensitivity and perpendicularity of resist pattern form.

Examples of propylene glycol, alkyl ether acetate include propylene glycol, methyl ether acetate, propylene glycol ethyl ether acetate, propylene glycol propyl ether acetate, and the like.

Particularly from the viewpoint of an effect and availability, etc., propylene glycol ethyl ether acetates are preferable. Propylene glycol alkyl ether acetates can be used as one kind or as mixture of two or more kinds thereof.

### - Mixture solvent

The (B) component comprises propylene glycol alkyl ether acetate blended with ethyl lactate.

When making a mixed solvent, the blending amount of propylene glycol alkyl ether acetate is comprised between 50 and 90 % by weight, and more desirably 70 to 90 % by weight.

Within this range, the effect by propylene glycol alkyl ether acetate is fully acquired.

Other solvents to be mixed can be one kind or a mixture of two or more kinds thereof.

Ethyl lactate can raise the heat resistance of the positive photoresist composition of the present invention, without greatly impairing the improvement effect of the development velocity of propylene glycol alkyl ether acetate, and is excellent.

Examples of other solvents which can be blended are ketones such as acetone, methyl ethyl ketone, cyclohexanone, methyl isoamylketone, 2-heptanone; polyhydric alcohols and the derivatives thereof (except for propylene glycol mono-acetate derivatives, propylene glycol alkyl ether-acetate), such as ethylene glycol, propylene glycol, diethylene glycol, ethylene glycol mono-acetate, propylene glycol, mono-acetate, diethylene glycol mono-acetate, or mono-methyl ether, mono-ethyl ether, mono-propyl ether, mono-butyl ether, or mono-phenyl ether thereof; ring type ethers, such as dioxane; and esters, such as methyl acetate, ethyl acetate, butyl acetate, methyl pyruvate, ethyl pyruvate, methoxy methyl propionate, and ethoxy ethyl propionate. These may be used independently, or two or more of them may be mixed and used.

Although the amount of the (B) components used is not limitted, it is desirable that solid content concentration in a positive photoresist composition account for the range of from 30 % by weight to 65 % by weight.

### Other components which can be blended

The positive photoresist of the present invention can further comprise, if necessary, plasticizers, such as an alkali soluble acrylate resin, an adhesion improver for increasing adhesion with a substrate, a sensitizer, a high boiling point organic solvents, an acid generating agent, or various addition components commonly used in the technical field concerned may be further blended with the positive photoresist composition of the present invention.

### - Alkali soluble acrylate resin

The positive photoresist composition of the present invention may comprise an alkali soluble acrylate resin (hereinafter referred to as "(C) component"), as a plasticizer, in order to raise anti-piating property, such as preventing generation of cracks, in the use of foming a thick film resist layer, and plating is applied.

As the component (C), materials that are generally blended with the positive photoresist composition as a plasticizer can be used.

As the component (C), those that contain 30 to 90 % by weight of a constitutional unit derived from a polymerizable compound which has an ether linkage and 50 to 2 % by weight of constitutional unit derived from a polymerizable compound which has a carboxyl group.

Examples of a polymerizable compound which has an ether linkage comprise radical polymerizable compounds, such as (meth)acrylic acid derivatives having an ether linkage and an ester linkage, such as 2-methoxy ethyl (meth)acrylate, methoxy triethylene glycol (meth)acrylate, 3-mehtoxy butyl (meth)acrylate, an ethyl carbitol (meth)acrylate, phenoxy polyethylene glycol (meth)acrylate, methoxy polypropylene glycol (meth)acrylate, tetra-hydrofurfuril (meth)acrylate. Preferably, they are 2-methoxyethyl acrylate and methoxy triethylene glycol acrylate.

These compounds can be used independently or in combination of two or more of them.

Examples of polymerizable compound which has a carboxyl group comprise radical polymerizable compounds, such as monocarboxylic acid, such as acrylic acid, methacrylic acid, and crotonic acid; dicarboxylic acid, such as maleic acid, fumaric acid, and itaconic acid; and methacrylic acid derivative which has a carboxyl group and ester bonds, such as 2-methacryloyloxy ethyl succinic acid, 2-methacryloyloxy ethyl maleate, 2-methacryloyl ethyl phthalic acid, and 2-methacryloyloxy ethyl hexahydro phthalic acid. Acrylic acid and methacrylic acid are preferable.

These compounds are used independently or two or more of them can be used in combination.

The content of a polymerizable compound which has an ether linkage in the (C) component preferably has 30 to 90 % by weight, more preferably 40 to 80 % by weight. By making the content 90 % by weight or less, a tendency of generation of BENARD CELLS (a pentagon to heptagon network pattern which has the heterogeneity produced on the coated film surface due to gravity or a surface tension slope) at the time of prebaking due to deterioration of the compatibility over the solution of the (A) component which makes it difficult to obtain a uniform resist film, can be controlled. By making the content 30 % by weight or more, the crack generation can be controlled in the use of forming a thick resist film resist layer and applying plating.

The content of a polymerizable compound which has a carboxyl group in the (C) component is preferably 2 to 50 % by weight, and more preferably 5 to 40 % by weight. By making the content 2 % by weight or more, the tendency that the alkali solubility of the positive photoresist composition of the present invention will decrease, and the tendency that sufficient developability will not be obtained can be prevented. Moreover, by making the content 2 % by weight or more, a tendency that the release property of the positive photoresist of the present invention decreases and some residue of the resist remains on a substrate can be controlled. By making the content 50 % by weight or less, the tendency that the remaining rate of the film after development decreases and plating resistance decreases can be controlled.

The average molecular weight of the (C) component is preferably 10,000 to 800,000, and more preferably 30,000 to 500,000. By making the molecular weight 10,000 or more, a tendency that a resist film cannot obtain sufficient hardness, and thus causes the blister of the profile at the time of plating, and generating of cracks can be controlled. By making the molecular weight 800,000 or less, the tendency for the releasability of a resist film to decrease can be controlled.

Furthermore in the (C) component, other radical polymerizable compounds can be included as a monomer in order to properly control a physical and chemical property. The above-mentioned "other radical polymerizable compounds" means radical polymerizable compounds other than the above-mentioned polymerizable compound.

Examples of such other radical polymerizable compound includes alkyl (meth)acryl esters, such as methyl (meth)acrylate, ethyl (meth)acrylate, butyl (meth)acrylate; hydroxy alkyl (meth)acrylate, such as 2-hydroxy ethyl (meth)acrylate, 2-hydroxy propyl (meth)acrylate; aryl (meth)acrylate, such as phenyl (meth)acyrlate, benzyl (meth)acrylate; dicarboxylic acid diesters, such as diethyl maleate, dibutyl fumarate; vinyl group containing aromatic compounds, such as styrene and α-methyl styrene; vinyl group containing aliphatic compound, such as vinyl acetate; conjugation diolefin, such as butadiene and isoprene; nitrile group containing polymerizable compound, such as acrylonitrile and methacrylonitrile; chlorine containing polymerizable compounds, such as vinyl chloride and vinylidene chloride; amide bond containing polymerizable compounds, such as acrylamide and methacrylamide, etc.

These compounds can be used independently or two or more of them can be used in combination. Among these, n-butyl acrylate, benzyl methacrylate, methyl methacrylate, and the like are especially desirable.

In the (C) component, other radical polymerizable compounds account for preferably 50 % by weight or less, and more preferably, 40 % by weight or less.

Examples of the polymerization solvent used for synthesis of the (C) component are alcohols, such as ethanol and diethylene glycol; ethylene glycol monomethyl ether; alkyl ethers of polyhydric alcohols, such as diethylene glycol monomethyl ether and diethylene glycol ethyl methyl ether; alkyl ether acetates of polyhydric alcohols, such as ethylene glycol ethyl ether acetate, propylene glycol methyl ether acetate; aromatic hydrocarbon, such as toluene, xylene; ketones, such as acetone and methyl isobutyl ketone; esters, such as ethyl acetate and butyl acetate. Among these, especially desirable are the alkyl ether of a polyhydric alcohol and the alkyl ether acetate of a polyhydric alcohol.

As the polymerization catalyst used for synthesis of the (C) component, the usual radical polymerization initiator can be used, and examples thereof includes azo compounds, such as 2,2'-azobis isobutyronitrile, and an organic peroxide, such as benzoyl peroxide and di-tert-butyl peroxide, and the like.

In the positive photoresist composition of the present invention, the blending amount of the (C) component account for 20 % by weight or less, and more preferably 10 % by weight or less based on the (A) component. By making the blending amount in this range, the hardness of the resist film formed will become sufficient, blistering etc., becomes unlikely to occur, a clear profile is obtained, and resolution improves.

In addition, although the (C) component is not indispensable, and it is not necessary to blend, when it is blended, more than 3 % by weight based on the (A) component is desirable.

### - Adhesion improver

Examples of an adhesion improver includes those disclosed in Japanese Unexamined Patent Application, First Publication No. S62-262043, Japanese Unexamined Patent Application, First Publication No. H11-223937, etc.

For example, 6-methyl-8-hydroxyquinoline, 6-ethyl-8-hydroxyquinoline, 5-methyl-8-hydroxyquinoline, 8-hydroxyquinoline, 8-acetyloxyquinoline, 4-hydroxypteridine, 2,4-dihydroxypteridine, 4-hydroxy pteridine-2-sulfonic acid, 2-ethyl-4-hydroxypteridine, 2-methyl-4-hydroxypteridine, 1,10-phenanthroline, 5,6-dimethyl-1,10-phenanthroline, 3,8-dimethyl-1,10-phenanthroline, 3,8-dihydroxy-1,10-phenanthroline, 5-carboxy-1,10-phenanthroline, 5,6-dihydroxy-1,10-phenanthroline, 1,10-phenanthroline-5-sulfonic acid, 4;4'-dimethyl-2,2'-bipyridyl, 2,2'-bipyridyl, 2, 2'-bipyridyl-5-carboxylic acid, 5,5'-dichloro-2,2'-bipyridyl, 3,3'-dihydroxy-2,2'-bipyridyl, 3,3'-dimercapto-2,2'-bipyridyl, etc. may be mentioned.

The adhesive property over the substrate of a positive photoresist composition can be remarkably raised by blending the heterocyclic aromatic compound which has on a ring at least one selected from the bonds represented by the following general formula (d-3) and at least one selected from the bonds represented by the following general formulas (d-1) and (d-2).

―N= (d-1)

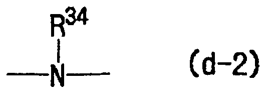

wherein R34 represents hydrogen atom or an alkyl group having 1 to 3 carbon atoms. 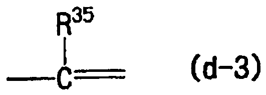 wherein R³⁵ represents hydroxyl group or an alkyl group of a linear or branched chain with 1 to 5 carbon atoms which have a hydroxyl group substituent.

The above-mentioned heterocyclic compound includes compounds indicated in "organic compound constitutional formula index" (issued by Maruzen Co., Ltd., on December 20, 1977) pp. 362-401, such as for example, those which have a 5 member ring frame with one nitrogen atom, such as an indole compound, an indoline compound and an indigo compound; those which have 6 member ring frame with one nitrogen atom, such as pyridine compound, quinoline compound, hydroquinoline compound, isoquinoline compound, acridine compound, a benzoquinoline compound, naphthoquinoline compound, phenanthroline compound; those which have 5 member ring frame with two nitrogen atoms, such as pyrazole compound, imidazole compound, imidazoline compound, and benzoimidazole compound; those which have 6 member ring frame with two nitrogen atoms, such as diazine compound, hydropyridine compound, benzodiazine compound, and dibenzodiazine compound; those which have 5 member ring frame with three nitrogen atoms, such as triazole compound, benzotriazole compound; those which have 6 member ring frame with three nitrogen atoms, such as triazine compound; those which have 5 member ring frame with 4 nitrogen atoms, such as tetrazole and pentetrazol; those which have 6 member ring frame with 4 nitrogen atoms, such as 1,2,4,5-tetrazine. In addition to these, purine compound, pteridine compound, alloxazine compound, 2H-pyrrole, etc., can be used.

Among these compounds, the compound represented by the following general formula (d-4) is desirable in that it provides a positive photoresist composition which controls generation of scums and is excellent in the adhesive property over a substrate. Especially, 2-(2-hydroxy ethyl) pyridine is desirable. 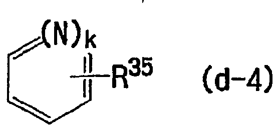 wherein k represents an integer of 1 to 3, and R³⁵ represents the same meaning as the above.

The addition amount of an adhesion improver is 0.1 to 1.0 % by weight, more preferably 0.2 to 0.7 % by weight based on the amount of sum totals of the above (A) component and the above (C) component. By making the amount 0.1 % by weight or more, the adhesive improvement effect over the substrate of a positive photoresist composition can fully be acquired. By making the amount 1.0 % by weight or less, the decrease in resolvability and the tendency to generate scums on the substrate after development can be controlled.

### - Sensitizer

According to the present invention, a sensitizer can be blended if necessary. As a sensitizer which can be used by the present invention, there is no restriction in particular. Sensitizers usually used in a positive photoresist composition can be chosen arbitrarily.
For example, the phenolic compound represented by the following general formula (e-1) can be used. 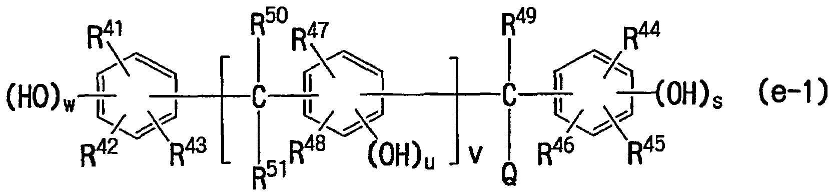 wherein R⁴¹ to R⁴⁸ each represents, independently, a hydrogen atom, a halogen atom, an alkyl group of 1 to 6 carbon atoms, an alkoxyl group of 1 to 6 carbon atoms, or a cycloalkyl group; R⁵⁰ and R⁵¹ each represents, independently, a hydrogen atom, or an alkyl group of 1 to 6 carbon atoms respectively; R⁴⁹ can be either a hydrogen atom or an alkyl group of 1 to 6 carbon atoms, and in such cases, Q is either a hydrogen atom, an alkyl group of 1 to 6 carbon atoms, or residue represented by a chemical formula (e-2) shown below: 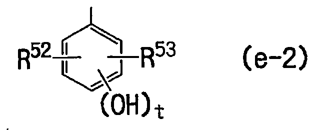 wherein, R⁵² and R⁵³ each represents, independently, a hydrogen atom, a halogen atom, an alkyl group of 1 to 6 carbon atoms, an alkoxyl group of 1 to 6 carbon atoms, or a cycloalkyl group; t represents an integer from 1 to 3; or Q can be bonded to R⁴⁹, and in such cases, Q and R⁴⁹, together with the carbon atom between R⁴⁹ and Q form a cycloalkyl group of 3 to 6 carbon atoms; w and s represent an integer of 1 to 3; u represents an integer of 0 to 3; although when w, s or u is 3, then R⁴³, R⁴⁶, or R⁴⁸ respectively do not exist; and v represents an integer of 0 to 3. Examples of the phenolic compound represented by the above general formula (e-1) include bis(4-hydroxy-2,3,5-trimethylphenyl)-2-hydroxyphenylmethane, 1,4-bis[1-(3,5-dimethyl-4-hydroxyphenyl) isopropyl] benzene, 2,4-bis(3,5-dimethyl-4-hydroxyphenylmethyl)-6-methylphenol, bis(4-hydroxy-3,5-dimethylphenyl)-2-hydroxyphenylmethane, , bis(4-hydroxy-2,5-dimethylphenyl)-2-hydroxyphenylmethane, bis(4-hydroxy-3,5-dimethylphenyl)-3,4-dihydroxyphnylmethane, 1-[1-(4-hydroxyphenyl) isopropyl]-4-[1,1-bis(4-hydroxyphenyl) ethyl] benzene, 1-[1-(3-methl-4-hydroxyphenyl) isopropyl]-4-[1,1-bis(3-methyl-4-hydroxyphenyl) ethyl]benzene, 2,6-bis[1-(2, 4-dihydroxyphenyl)isopropyl]-4-methylphenol, 4,6-bis[1-(4-hydroxyphenyl)isopropyl]resorcin, 4,6-bis(3,5-dimethoxy-4-hydroxyphenylmethyl)pyrogallol, 4,6-bis(3,5-dimethyl-4-hydroxyphenylmethyl)pyrogallol, 2,6-bis(3-methyl-4,6-dihydroxyphenymethyl)-4-methyl phenol, 2,6-bis(2,3,4-trihydroxyphenylmethyl)-4-methyl phenol, 1,1-bis(4-hydroxyphenyl)cyclohexane etc. may be mentioned. In addition to these, 6-hydroxy-4a-(2,4-dihydroxyphenyl)-9-1' -spirocyclohexyl-1,2,3,4,4a,9a-hexahydroxanthene, 6-hydroxy-5-methyl-4a-(2,4-dihydroxy-3-methylphenyl)-9-1' -spirocyclohexyl-1,2,3,4,4a,9a-hexahydroxanthene, and the like can be used.

These sensitizers can be used independently, or two or more of them can be mixed and used. Among these, a combination of 1-[1-(4-hydroxyphenyl) isopropyl]-4-[1,1-bis(4-hydroxyphenyl) ethyl]benzene and bis(4-hydroxy-2,3,5-trimethylphenyl)-2-hydroxyphenylmethane is especially superior in increasing sensitivity and the perpendicularity of a space pattern.

As a sensitizer, the phenolic compound represented by the following general formula (e-3) can be used.

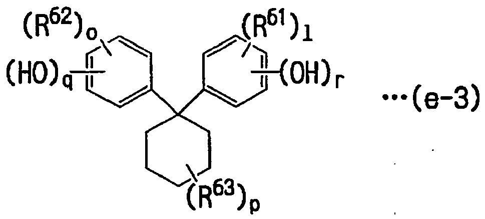

In the general formula (e-3), R⁶¹ to R⁶³ each independently represents a lower alkyl group (which may be linear or branched, and has preferably 1 to 5 carbon atoms, more preferably 1 to 3 carbon atoms), cycloalkyl group (preferably of 5 to 7 carbon atoms) or a lower alkoxy group (which may be linear or branched, and has preferably 1 to 5 carbon atoms, more preferably 1 to 3 carbon atoms) independently among a general formula (e-3). q and r represent an integer from 1 to 3, preferably 1 to 2. 1, o, and p represent an integer of 0, or 1 to 3.

More specifically, as a phenolic compound represented by the general formula (e-3), the compounds represented by the following chemical formula (e-4) to (e-8) are mentioned.

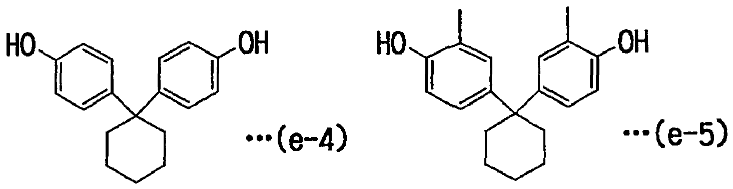

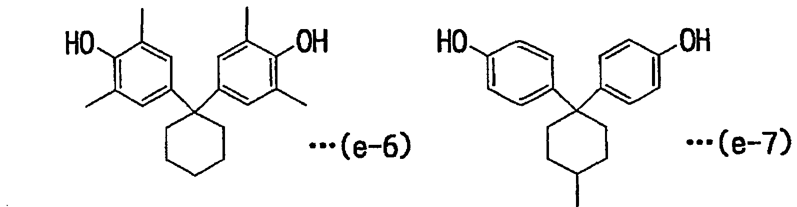

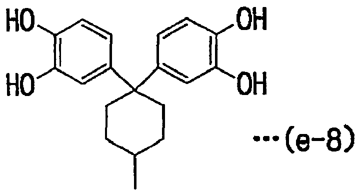

As a sensitizer, the phenolic compound represented by the following general formula (e-9) can also be used.

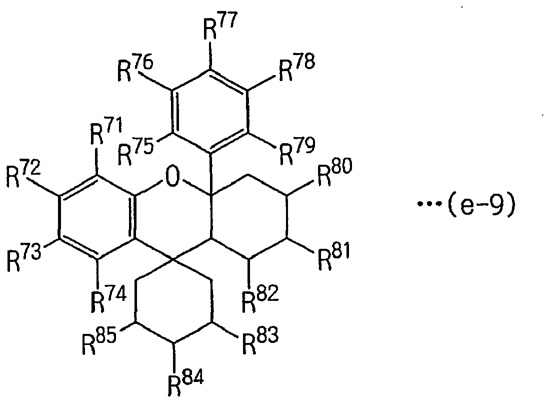

In the general formula (e-9), R⁷¹ to R⁷⁹ each independently represents a hydrogen atom, an alkyl group, a halogen atom, or a hydroxyl group. At least one of them is a hydroxyl group, and preferably at least 1 of R⁷¹ to R⁷⁴ and at least 1 of R⁷⁵ to R⁷⁹ are hydroxyl group. Any alkyl group in R⁷¹ to R⁷⁹ may be linear or branched, and has preferably 1 to 5 carbon atoms, more preferably 1 to 3 carbon atoms.

R⁸⁰ to R⁸⁵ each independently represents a hydrogen atom, an alkyl group, an alkenyl group, a cycloalkyl group, or an aryl group. Any alkyl group in R⁸⁰ to R⁸⁵, may be linear or branched, and has preferably 1 to 5 carbon atoms. As an alkenyl group, an alkenyl group of 1 to 4 carbon atoms is desirable.

More specifically, as a phenolic compound represented by a general formula (e-9), the compounds represented by the following general formula (e-10) may be mentioned. 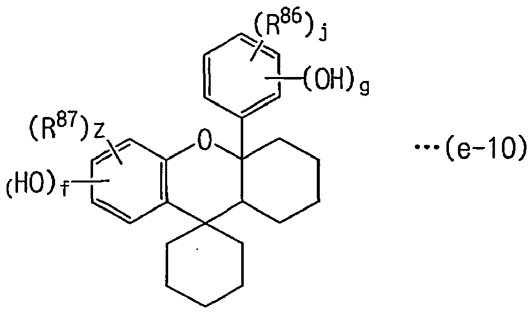 wherein R⁸⁶ and R⁸⁷ each independently represents an alkyl group. The alkyl groups may be linear or branched, and have preferably 1 to 5 carbon atoms, more preferably 1 to 3 carbon atoms. f and g represents an integer of 1 to 3, preferably 1 or 2. j and z represents an integer of 0, or 1 to 3.

More specifically, as a phenolic compound represented by a general formula (e-9), the compounds represented by the following formula (e-11) or (e-12) may be mentioned.

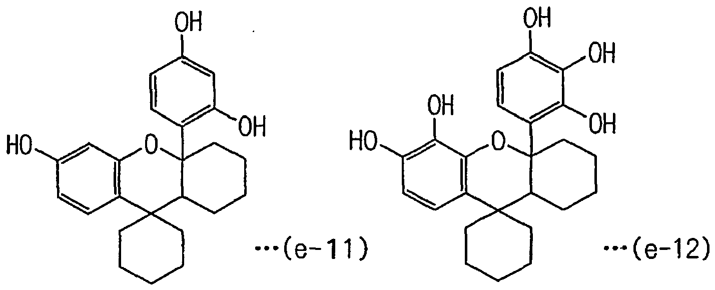

The blending amount of the sensitizer is preferably 1 to 30 % by weight and more preferably 3 to 20 % by weight, based on the above (A) component.

### - High boiling point organic solvent

Furthermore, in the present invention, by adding an optional organic solvent selected from a group consisting of high boiling point organic solvents with a boiling points of 200 to 350°C, the bulk effect of the resist film, namely bias within the film density, can be reduced, meaning that even in those cases when the positive photoresist composition is used to form a thick resist film on the surface of a substrate with level differences, a resist pattern with excellent perpendicularity can still be formed. Furthermore, a favourable resist pattern can be formed regardless of the conditions (heating time, heating devices and the like) for the prebake treatment and the PEB (post exposure heating) treatment.

Examples of the above high boiling point organic solvents include benzyl acetate, isoamyl salicylate, methyl salicylate, benzyl salicylate, diethyl phthalate, dibutyl phthalate, dimethyl phthalate, γ-butyrolactone, ethyl benzoate , butyl benzoate, propyl benzoate, benzyl benzoate, ethylene glycol mono-phenyl ether, ethylene glycol mono-hexyl ether, 1, 3-octylene glycol, diethylene glycol, diethylene glycol diacetate, diethylene glycol dibutyl ether, diethylene glycol monoethyl ether, diethylene glycol monoethyl ether acetate, diethylene glycol mono butyl ether, diethylene glycol monobutyl ether acetate, dipropylene glycol, dipropylene glycol mono butyl ether, triethylene glycol, triethylene glycol di-2-ethyl butylate, triethylene glycol dimethyl ether, triethylene glycol monoethyl ether, triethylene glycol monomethyl ether, tripropylene glycol, tripropylene glycol monomethyl ether, 2-ethyl hexanoic acid, caprylic acid, caproic acid, catechol, octylphenol, and N-methyl pyrrolidone. These organic solvents may be used singularly, or in combination of two or more different solvents. Of the above solvents, those with a boiling point within the range from 250 to 350°C are preferred, and benzil salicylate is particularly desirable.

The quantity added of the high boiling point organic solvent is typically within a range from 3 to 15 % by weight, and preferably from 6 to 12 % by weight based on the combined quantity of the component (A), and if added, the above sensitizer. If the quantity is 3 % by weight or more, then the above effect can be sufficient, whereas, if the quantity is 15 % by weight or less, then a tendency is controlled that the upper sections of the space pattern to expand, causing an undesirable deterioration in the perpendicularity of the cross sectional shape.

### Preparation method of the positive photoresist composition

The positive photoresist composition of the present invention is prepared by dissolving the above (A) component and the various components added if needed in the (B) component, and it is used in the form of a solution. Preparation of a positive photoresist composition according to the present invention may be conducted simply by mixing and stirring together each of the components described above using normal methods, or if necessary, by dispersion and mixing using a dispersion device such as a dissolver, a homogenizer or three roll mill. Furthermore, following mixing of the components, the composition may also be filtered using a mesh or a membrane filter or the like.

### [Resist pattern formation method]

A description follows of a preferred example of a method of forming a resist pattern according to the present invention.

First, the above positive photoresist composition is applied to the surface formed from a material such as Au, Si, and Cu, or the like using a spinner or the like, and is then dried to form a photosensitive layer. This photosensitive layer is then exposed through a desired mask pattern, using a light source, such as a high pressure mercury lamp, an ultra high pressure mercury lamp, or a low pressure mercury lamp. Where required, a PEB (post exposure baking) treatment is then performed, and the exposed portions of the film are then dissolved and removed by immersing the substrate in a developing liquid, for example, an alkaline aqueous solution such as a 1 to 10% by weight aqueous solution of tetramethylammonium hydroxide (TMAH), thus forming an image which is faithful to the mask pattern.

In those cases where a resist pattern with a high aspect ratio with a width of no more than 0.8 µm is formed under thick film conditions of at least 3 µm, and particularly from 6 to 8 µm, a conventional pattern formation method using an acid cross linking material can also be used if required.

Examples of such conventional methods include resist pattern formation methods comprising the steps of forming a film of an acid cross linking material, which causes a cross linking reaction under the action of acid, across the entire surface of the substrate on which the resist pattern has been drawn, conducting heat treatment so that the action of acid diffusing from the resist pattern surface causes cross linking of the acid cross linking material in those portions contacting the resist pattern, and using a developing liquid to remove the acid cross linking material from those areas that have not undergone cross linking, thereby forming a resist pattern with a narrower space width than that of the resist pattern prior to formation of the acid cross linking material film. Other examples include resist pattern formation methods comprising the steps of: forming a film of an acid cross linking material, which causes a cross linking reaction under the action of acid, across the entire surface of the substrate on which the resist pattern has been drawn, generating acid at the surface of, or inside, the resist pattern by conducting either selective exposure or complete exposure of the substrate surface using ultraviolet radiation, conducting heat treatment so that the action of acid diffusing from the resist pattern surface causes cross linking of the acid cross linking material in those portions contacting the resist pattern, and using a developing liquid to remove the acid cross linking material from those areas that have not undergone cross linking, thereby forming a resist pattern with a narrower space width than that of the resist pattern prior to formation of the acid cross linking material film.

There are no particular restrictions on the acid cross linking material and the developing liquid used, and suitable examples include the materials disclosed in Japanese Unexamined Patent Application, First Publication No. Hei 11-204399.

In the present invention the development velocity can be increased by using the (B) component in the positive photoresist composition and the resist pattern formation method. Moreover, the thickness loss by development can be prevented. Good sensitivity is obtained by using the (A) component.

Moreover, a surfactant can also be blended with the composition of the present invention if needed in order to raise coating performance, anti-foaming property, leveling property, etc. Surfactants, such as fluorine based surfactants such as for example BM-1000, BM-1100 (trade name, manufactured by BM Chemie), MEGAFAC F142D, MEGAFAC F172, MEGAFAC F173, MEGAFAC F183 (manufactured by Dainippon Ink & Chemicals, Inc.), FLUORAD FC-135, FLUORAD FC-170C, FLUORAD FC-430, FLUOLAD FC-431 (manufacrured by Sumitomo 3M Co., Ltd.), SURFRON S-112, SURFRON S-113, SURFRON S-131, SURFRON S-141, SURFRONS-145 (trade name, manufactured by Asahi Glass Co., Ltd.), SH-28PA, SH-190, SH-193, SZ-6032, SF-8428 (trade name, manufactured by Dow Corning Toray Silicone Co.,Ltd.), etc., can be used in the present invention. The amount of these surfactants used is preferably 1 % by weight or less, based on the total resist solid component.

### [Examples]

### (Synthetic Example)

50g of a polycondensation product (1) (Mw=4000, dispersity (Mw/Mn)=5.0, synthesized by a dehydration condensation reaction of m-cresol, p-cresol (molar ratio = 36:64) and formalin, and 5g of 1,2-naphthoquinonediazide-5-sulfonyl chloride were placed in a 1 liter 3-necked flask equipped with a thermometer, a stirrer, and a dropping funnel. 150 g of 2-heptanone was then added to dissolve the mixture, and 3.8 g of triethylamine was added from the dropping funnel. The reaction mixture was then stirred for 1 hour at room temperature to allow the reaction to proceed.

Subsequently, 5.8 g of a 35% aqueous hydrochloric acid solution was added, and futher stirring was continued at room temperature for 30 minutes. Next, to this reaction product solution, 150g of water was added and agitated, thereafter, superfluous hydrochloric acid was removed by standing the reaction product solution and removing the separated aqueous layer. By the above operation, 2-heptanone solution of the photosensitive novolak resin (2) wich is formed by replaying 4.5 mol % of hydrogen atoms within those of all phenolic hydroxyl groups were replaced by 1,2-nalphthoquinonediazide-5-sulfonyl group.

### (Example 1) (Not part of the present invention)

The above 2-heptanone solution of the photosensitive novolak resin (2) was concentrated, and operation of adding propylene glycol methyl ether acetate thereto and concentrating thereof was repeated 3 times, and 55 % by weight solution ot novolak resin (2) in propylene glycol, methyl ether acetate was obtained.

Subsequently, propylene glycol methyl ether acetate was added so that the concentration of photosensitive novolak resin (2) might become 42 % by weight, to 100 weight part of the photosensitive novolak resin (2) (182 weight part of the 55 % by weight solution of propylene glycol, methyl ether acetate), and a positive photoresist composition which contains propylene glycol methyl ether acetate as the solvent was prepared.

### (Example 2)

By adding propylene glycol methyl ether acetate and ethyl lactate so that the concentration of photosensitive novolak resin (2) may become 42 % by weight, to 100 weight part of the photosensitive novolak resin (2) (182 weight part of the 55 % by weight solution of propylene glycol methyl ether acetate), and a positive photoresist composition which contains propylene glycol methyl ether acetate and ethyl lactate (weight ratio = 70/30) as the solvent was prepared.

### (Comparative Example 1)

The above 2-heptanone solution of photosensitive novolak resin (2) was concentrated, and operation of adding ethyl lactate thereto and concentrating thereof was repeated 3 times, and 55 % by weight solution of photosensitive novolak resin (2) in ethyl lactate was obtained.

By adding ethyl lactate so that photosensitive novolak resin (2) concentration may become 42 % by weight solution of photosensitive novolak resin (2) (182 weight part of the 55 % by weight solution of ethyl lactate), and a positive photoresist composition which contain ethyl lactate as the solvent was prepared.

### (Comparative Example 2)

By concentrating 2-heptanone solution of photosensitive novolak resin (2), a 55 % by weight solution of 2-heptanone was obtained.

By adding 2-heptanone so that novolak resin (2) concentration may become 42 % by weight solution of photosensitive novolak resin (2) (182 weight part of the 55 % by weight solutions of 2-heptanone), and a positive photoresist composition which contain 2-heptanone as the solvent was prepared.

### (Comparative Example 3)

Component (A-1): Polycondensation material (1) 100 weight part
Component (A-2): A photosensitizer formed by replacing two mols of the hydrogen atom within those of all phenolic hydroxyl groups of 1-[1-(4-hydroxyphenyl) isopropyl]-4-[1,1-bis(4-hydroxyphenyl) ethyl] benzene by 1,2-naphthoquinonediazide-5-sulfonyl group 18 weight parts

By adding propylene glycol methyl ether acetate so that sum total concentration of each of the above components may become 42 % by weight, a positive photoresist composition which contained propylene glycol methyl ether acetate as the solvent was prepared.

The positive photoresist compositions of the examples and comparative examples prepared by the above method were estimated, and the results are shown in Table 1.

### (Developability evaluation)

The samples were applied with a spinner on an Si substrate which had been treated by hexamethyl disilazane (HMDS), and was then dried on a hotplate at 100°C for 90 seconds, thus forming a resist film with a film thickness of 5.0 µm.

Subsequently the film was exposed so that a line:space might be finished 1:1 on this film using a reduction projection exposure apparatus NSR-2005i10D (manufactured by NIKON CORP., NA = 0.50) through a mask with which a predetermined shading pattern (5 µm line & space) was drawn.

Subsequently, as development operation, a 23°C 2.38 % by weight tetra-methylammonium hydroxide (TMAH) aqueous solution was applied on a substrate, and after 30 seconds contact, was removed by rotating the spinner. This processing of rotation removement was repeated until an observation after a rotation removement exhibited a pattern wherein the space portion was removed and the line:space becomes 1:1.

The developability was assessed by the number of the rotation removement. Two or less of the number was ranked as A; 3 of the number was ranked as B; 4 of the number was ranked as C; 5 or more of the number was ranked as D.

### (Sensitivity evaluation)

Application, exposure, and development were performed in the same way as the above Developability evaluation, and the light exposure (E) required to form a 5 µm was recorded. The sensitivity was estimated as A, when E≤500ms; and as C, when 500 ms < E.

### (Resist form evaluation)

Exposure and development were performed in the same way as the above Developability evaluation, and the angle (R) between the side wall of a 5 µm line and a substrate was measured. The resist form was evaluated as A, when 85° <R; as B, when 70°< R≤85° ; and as C, when R≤70°.

### (Heat resistance evaluation)

The samples were applied with a spinner on a substrate which had been treated by HMDS, and was then dried on a hotplate at 100°C for 90 seconds, thus forming a resist film with a film thickness of 3.0 µm.

Subsequently, the film was exposed, through a mask with a mask dimensions of 5 µm (for forming a 5 µm line pattern), using a reduction projection exposure apparatus NSR-2005i10D (manufactured by NIKON CORP., NA = 0.50), so that a 5 µm line pattern was formed, and the film was then subjected to PEB treatment at 100 ° C for 90 seconds.

As the developing operation, a 2.38% by weight aqueous solution of tetramethylammonium hydroxide (TMAH) at 23°C was then applied to the substrate surface, and after 60 seconds contact, was removed by rotating the spinner. The film was then washed with water for 30 seconds and dried, and the resulting substrate with 5 µm line pattern thereon was subjected to heat treatment on a hotplate at 120°C for 600 seconds.

The cross sectional shape of the 5 µm line pattern was then viewed via a SEM (scanning electron microscope) photograph, and the angle between the substrate interface and a straight line connecting the point of intersection (point (a) in FIG. 1) between the substrate interface and the side wall of the resist pattern, and the corner (point (b) in FIG. 1) at the top of the resist pattern was termed θ. Patterns for which θ> 80° were recorded as "A", patterns for which 80° ≧ θ and in which the corner still existed at the top of the resist pattern were recorded as "B", and patterns in which the corner no longer existed at the top of the resist pattern, making measurement impossible, were recorded as "C".

**Table 1**

| | Developability evaluation | Sensitivity evaluation | Resist form evaluation | Heat resistance evaluation |
|---|---|---|---|---|
| Example 1* | A | A | A | B |
| Example 2 | B | A | A | A |
| Comp. Ex. 1 | C | A | A | A |
| Comp. Ex. 2 | D | A | B | A |
| Comp. Ex. 3 | A | C | C | C |

| | | | | |
|---|---|---|---|---|
| * Not part of the present invention. | | | | |

From the result shown in Table 1, the positive photoresist composition of the present invention apparently provide good results in both development velocity and sensitivity, and improves development velocity while maintaining the characteristics of the (A) component. Moreover, in resist form evaluation, the phenomenon of the head of a pattern becoming round was not observed, but a high perpendicularity was obtained. Furthermore, heat-resistant evaluation increased in Example 2, wherein a mixed solvent of propylene glycol methyl ether acetate and ethyl lactate was used. In Example 2, although the developability evaluation of the positive photoresist composition decreased slightly, it was satisfactory for practical use.

## Claims

1. A positive photoresist composition comprising a dissolution of (A) a photosensitive novolak resin obtainable by substituting 2-20 mol % of hydrogen atoms within those of all phenolic hydroxyl groups of an alkali soluble novolak resin by 1,2-naphthoquinone diazide sulfonyl groups and (B) an organic solvent containing ethyl lactate and 50 to 90 weight % of a propylene glycol alkyl ether acetate by weight of mixed solvent,
wherein the alkali soluble novolak resin of the (A) component before substitution by 1,2-naphthoquinone diazide sulfonyl groups has the following characteristics (1) - (3):
(1) a polystyrene equivalent weight average molecular weight of 1000 to 30000,
(2) a degree of dispersion of 25 or less, and
(3) a rate of dissolution in a 2.38 % by weight TMAH (tetra-methyl ammonium hydroxide) aqueous solution at 23°C comprised between 10 and 1000Å/s,=

2. The positive photoresist composition according to claim 1, wherein the propylene glycol alkyl ether acetate is propylene methyl ether acetate.

3. A resist pattern formation method comprising the steps of coating a positive photoresist composition according to Claim 1 or 2 on a substrate, prebaking the coated film, selectively exposing the film, and subsequently alkali developing the film.

## Patentansprüche

1. Positiv-Fotolackzusammensetzung, umfassend eine Lösung von (A) einem fotosensitiven Novolak-Harz, erhältlich durch Substituieren von 2 - 20 mol% der Wasserstoffatome unter jenen aller phenolischen Hydroxylgruppen eines alkalilöslichen Novolak-Harzes durch 1,2-Naphthochinondiazidsulfonylgruppen in (B) einem organischen Lösungsmittel, das Ethyllactat und 50 bis 90 Gew.-% eines Propylenglykolalkyletheracetates pro Gewicht an gemischtem Lösungsmittel enthält, wobei das alkali-lösliche Novolak-Harz mit dem Bestandteil (A) vor Substitution durch 1,2-Naphthochinondiazidsulfonylgruppen, die folgenden Merkmale (1) bis (3) aufweist:
(1) ein durchschnittliches Polystyroläquivalentmolekulargewicht von 1.000 bis 30.000,
(2) einen Dispersionsgrad von 25 oder weniger und
(3) eine Lösungsgeschwindigkeit in einer wässrigen 2,38 Gew.-% TMAH-Lösung (Tetramethylammoniumhydroxid) bei 23° Celsius zwischen 10 und 1.000 Å/s.

2. Positiv-Fotolackzusammensetzung nach Anspruch 1, wobei das Propylenglykolalkyletheracetat Propylenglykolmethyletheracetat ist.

3. Resistmusterausbildungsverfahren, umfassend die Schritte vom Beschichten einer Positiv-Fotolackzusammensetzung nach Anspruch 1 oder 2 auf ein Substrat, Vorbacken des beschichteten Films, selektives Belichten des Films und anschließendes Alkalientwickeln des Films.

## Revendications

1. Composition de photorésist positif comprenant une dissolution de (A) une résine novolaque photosensible pouvant être obtenue par substitution de 2-20 mol % d'atomes d'hydrogène parmi ceux de tous les groupes hydroxyle phénoliques d'une résine novolaque soluble en milieu alcalin par des groupes 1,2-naphtoquinone diazide sulfonyle dans (B) un solvant organique contenant du lactate d'éthyle et 50 à 90 % en poids d'un acétate d'alkyléther de propylèneglycol en poids du mélange de solvants, où la résine novolaque soluble en milieu alcalin du composant (A) avant la substitution par des groupes 1,2-naphtoquinone diazide sulfonyle a les caractéristiques (1) à (3) suivantes :
(1) une masse moléculaire moyenne en poids équivalente au polystyrène de 1 000 à 30 000,
(2) un degré de dispersion de 25 ou moins, et
(3) une vitesse de dissolution dans une solution aqueuse de TMAH (hydroxyde de tétraméthylammonium) à 2,38 % en poids comprise entre 10 et 1 000 Å/s.

2. Composition de photorésist positif selon la revendication 1 où l'acétate d'alkyléther de propylèneglycol est l'acétate de méthyléther de propylèneglycol.

3. Procédé de formation d'un motif de résist comprenant les étapes d'application en revêtement d'une composition de photorésist positif selon la revendication 1 ou 2 sur un substrat, de pré-cuisson du film appliqué en revêtement, d'exposition sélective du film puis de développement du film en milieu alcalin.
